# FASCICULE DE BREVET EUROPEEN

(11) **EP 3 059 763 B1**
(45) Date de publication et mention de la délivrance du brevet: **19.06.2019**
(21) Numéro de dépôt: 16156165.9
(22) Date de dépôt: 17.02.2016
(51) Int. Cl.: H01L 25/10, H01L 23/495, H01L 21/48

(54) **PROCEDE DE FABRICATION D'UN MODULE ELECTRONIQUE 3D A BROCHES EXTERNES D'INTERCONNEXION**
HERSTELLUNGSVERFAHREN EINES ELEKTRONISCHEN 3D-MODULS MIT EXTERNEN VERBINDUNGSSTIFTEN
METHOD FOR MANUFACTURING A 3D ELECTRONIC MODULE WITH EXTERNAL INTERCONNECTION LEADS

(30) Priorité: 20.02.2015 FR 1551445
(43) Date de publication de la demande: 24.08.2016
(73) Titulaire: 3D Plus, 78530 Buc (FR)
(72) Inventeur: VAL, Alexandre, 78150 LE CHESNAY (FR); SOUFFLET, Fabrice, 91570 BIEVRES (FR)
(74) Mandataire: Henriot, Marie-Pierre

(56) Documents cités:
- WO-A1-01/59841
- FR-A- 1 487 033
- FR-A1- 2 688 630
- US-A- 5 602 420

## Description

Le domaine de l'invention est celui des modules électroniques 3D et plus particulièrement de l'interconnexion externe de ces modules 3D. La réalisation des systèmes électroniques actuels, tant civils que militaires, doit tenir compte d'exigences de plus en plus grandes de compacité, du fait du nombre de plus en plus élevé de circuits mis en oeuvre.

Dans cette recherche de plus grande compacité, il a déjà été proposé de réaliser des empilements de boîtiers encapsulant des composants électroniques actifs ou passifs, comme décrit dans les brevets français FR 2 688 630 et FR 2 805 082 ; l'interconnexion s'effectue en trois dimensions en utilisant les faces de l'empilement comme surfaces d'interconnexion pour réaliser les connexions entre broches de sortie des boîtiers. En effet, un boîtier encapsulant un ou plusieurs composants électroniques comporte également des connecteurs électriques (fils ou pistes par exemple) reliant les plots de connexion des composants à des broches de sortie qui émergent typiquement sur deux côtés opposés du boîtier. Le procédé décrit dans le brevet français FR 2 805 082 permet notamment de réduire les dimensions du module 3D dans le plan des boîtiers, en découpant le bloc à travers ces boîtiers et non plus à l'extérieur des boîtiers comme décrit dans le brevet FR 2 688 630.

L'encapsulage des composants électroniques dans des boîtiers plastiques, tels que par exemple les boîtiers standards du type SOJ ("Small Outline J-lead"), TSOP ("Thin Small Outline Package") ou CSP ("Chip Scale Package") présente de nombreux avantages. Tout d'abord, ces boîtiers ont été testés et déverminés par le constructeur alors que ces opérations sont très difficiles à mener sur les puces nues. Par ailleurs, il est généralement difficile d'obtenir des puces nues auprès des constructeurs. L'ensemble de ces raisons conduit donc à privilégier l'utilisation de boîtiers, nettement moins coûteuse et plus facile. L'empilage de boîtiers selon les solutions des brevets mentionnés plus haut implique les opérations principales suivantes : décambrage éventuel des broches de sortie pour faciliter le centrage et le moulage ; empilage des boîtiers plastiques ; enrobage par résine et polymérisation ; découpage du bloc ; métallisation ; gravure des contours des connexions sur les faces du bloc.

Le module 3D intègre un système d'interconnexion électrique du module 3D avec l'extérieur aussi désigné connectique SoP (« Small outline Package ») comportant de manière classique :
- éventuellement un circuit imprimé assemblé et électriquement relié par une face à l'empilement de boîtiers, et
- une grille d'adaptation (ou « leadframe » en anglais) constituée d'une couche de métal (sont communément utilisés des alliages de FeNiCo ou FeNi ou Cu) évidée en son centre pour recevoir le circuit imprimé et comportant des broches ayant chacune deux extrémités. Des extrémités des broches sont assemblées aux bords du circuit imprimé (sur la face opposée à celle qui est assemblée à l'empilement). Une fois le module 3D fabriqué, les autres extrémités des broches sortent par le dessous du module 3D et sont généralement mises en forme en vue de l'assemblage ultérieur du module 3D sur carte imprimée par exemple. La grille comporte généralement des moyens pour solidariser les extrémités des broches entre elles afin de faciliter leur mise en forme.

Cette connectique SoP équipe la plupart des modules 3D.

Un tel module 3D présente plusieurs inconvénients. Lorsque les broches de sortie ne sont pas mises en forme et sortent donc selon la direction de l'empilement (direction Z sur les figures) sous forme de broches verticales, la hauteur du module 3D en est augmentée d'autant ce qui va à l'encontre de la compacité recherchée. De plus les équipements de pose automatique (de type « Pick and Place ») sont difficiles à utiliser lors de l'assemblage sur carte imprimée du fait de la fragilité de ces broches verticales, et les joints de brasure utilisés lors de l'assemblage ne peuvent être contrôlés efficacement.

Une solution consiste donc à mettre en forme les broches de sortie (qui sortent sous le module) en les coudant sous forme par exemple d'ailes de mouette (« Gullwing »). Mais des micro-fissures apparaissent souvent au niveau de ces coudes ce qui détériore la qualité de leurs propriétés mécaniques et électriques.

En conséquence, il demeure à ce jour un besoin pour un procédé de fabrication d'un module 3D donnant simultanément satisfaction à l'ensemble des exigences précitées, en termes de qualité de connexion électrique, de facilité de pose du module 3D lors de son assemblage sur une carte et de contrôle de l'assemblage.

L'invention est basée sur une modification de la connectique. Selon l'aspect le plus général de l'invention, les broches de sortie du circuit de connectique sortent sur les faces où se trouve l'interconnexion verticale propre au procédé de fabrication des modules 3D, et non plus en dessous.

Plus précisément, le procédé de fabrication d'au moins un module électronique 3D comprenant chacun un empilement selon une direction Z de boîtiers électroniques et/ou de circuits imprimés, disposé sur un système d'interconnexion électrique du module 3D avec l'extérieur, à broches métalliques ayant des extrémités, principalement caractérisé en ce qu'il comporte les étapes suivantes :
- à partir d'une grille d'interconnexion qui comprend des broches métalliques ayant chacune deux extrémités, l'une vers l'intérieur de la grille, l'autre vers l'extérieur de la grille, plier à environ 180° les extrémités intérieures des broches pour obtenir une partie de grille dite interne incluant les extrémités pliées et destinées à être moulées, l'autre partie dite externe incluant les extrémités non pliées, les deux extrémités de chaque broche étant destinées à émerger du module 3D sur une même face découpée selon Z,
- déposer sur toute la grille ainsi pliée un revêtement métallique compatible d'étapes ultérieures de collage et/ou de brasage de la partie externe,
- placer la partie externe de la grille métallisée entre un élément de protection inférieur et un élément de protection supérieur en laissant libre la partie interne, et placer cet ensemble grille et éléments de protection sur un support,
- placer chaque empilement de boîtiers et/ou de circuits imprimés équipés chacun d'au moins un composant électronique et de pattes extérieures d'interconnexion électrique entre boîtiers et/ou circuits imprimés, de manière à superposer les pattes extérieures sur la partie interne,
- mouler dans une résine de type époxyde, l'empilement et ses pattes extérieures et la partie interne en recouvrant partiellement l'élément de protection supérieur,
- découper la résine selon Z en laissant affleurer les sections conductrices des pattes extérieures et des extrémités des broches de la partie interne, et en formant ainsi des faces découpées selon Z, et retirer la résine de l'élément de protection supérieur,
- métallisation des faces découpées présentant les sections conductrices,
- retrait du support,
- retrait des éléments de protection pour dégager les broches de la partie externe.

Le module 3D ainsi obtenu ne présente pas de faiblesse au niveau de la partie pliée des broches puisqu'elles sont métallisées après ce pliage. Il permet aussi un contrôle plus aisé des joints de brasure lors de l'assemblage sur carte imprimée puisque ces joints ne sont plus cachés sous le module, et facilite l'utilisation du module 3D par les équipements de pose automatique (de type Pick and Place) lors de l'assemblage sur carte.

Les broches dégagées de la partie externe peuvent être cambrées.

Les faces découpées métallisées sont gravées pour réaliser l'interconnexion verticale.

De préférence, un élément d'étanchéité est disposé entre les éléments de protection lors du placement de la partie externe entre ces éléments de protection ; il est retiré lors du retrait des éléments de protection.

Selon une caractéristique de l'invention, les pattes extérieures des boîtiers sont présentes sur quatre côtés et la grille d'interconnexion comporte deux sous-grilles placées l'une sur l'autre et perpendiculairement l'une par rapport à l'autre et comportant chacune des broches, les broches de la première sous-grille étant connectées à deux faces opposées de l'empilement, les broches de la deuxième sous-grille étant connectées aux deux autre faces opposées de l'empilement.

Selon une autre caractéristique de l'invention, la grille est une multigrille, par exemple à 5 motifs.

L'invention a aussi pour objet un module électronique 3D selon la revendication 7 comportant, en particulier:
- un empilement de boîtiers et/ou de circuits imprimés électroniques,
- selon la direction de l'empilement, des faces d'interconnexion des boîtiers et/ou circuits imprimés, et
- un système de connexion du module 3D avec l'extérieur, à broches métalliques,
   les deux extrémités de chaque broche émergeant sur une même face d'interconnexion.

D'autres caractéristiques et avantages de l'invention apparaîtront à la lecture de la description détaillée qui suit, faite à titre d'exemple non limitatif et en référence aux dessins annexés dans lesquels :
la figure 1 représente schématiquement une grille de connexion selon l'état de la technique, vue en perspective,
les figures 2a à 2i illustrent schématiquement les principales étapes du procédé selon l'invention, les vues étant présentées en coupe selon l'axe AA' de la figure 1,
les figures 3 représentent schématiquement un exemple de module 3D obtenu par le procédé selon l'invention, vu en perspective, à broches externes cambrées (fig 3a) ou plates (fig 3b),
les figures 4 représentent en perspective une grille à deux sous-grilles placées perpendiculairement l'une par rapport à l'autre (fig 4a) et un empilement à 4 faces d'interconnexion verticale placé sur cette grille (fig 4b),
la figure 5 représente en perspective une multigrille à 5 motifs.

D'une figure à l'autre, les mêmes éléments sont repérés par les mêmes références.

Dans la suite de la description, les expressions « inférieur », « supérieur », « dessus », « dessous », « vertical », sont utilisées en référence à l'orientation des figures décrites. Dans la mesure où le dispositif peut être positionné selon d'autres orientations, la terminologie directionnelle est indiquée à titre d'illustration et n'est pas limitative.

Les principales étapes du procédé de fabrication selon l'invention sont les suivantes.

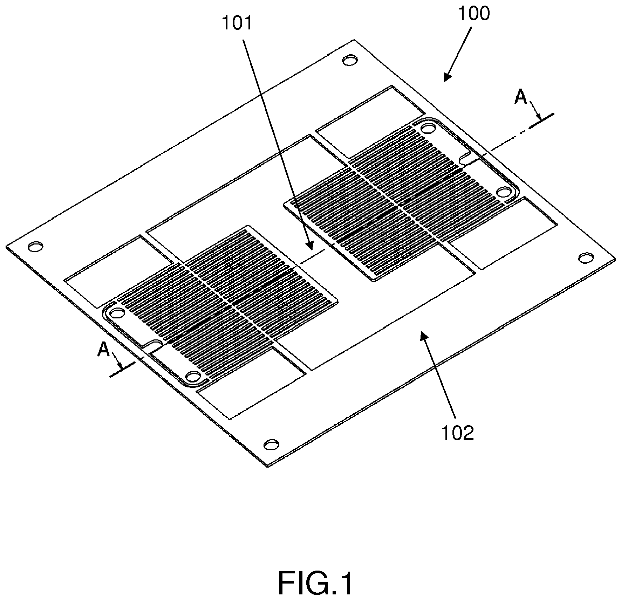

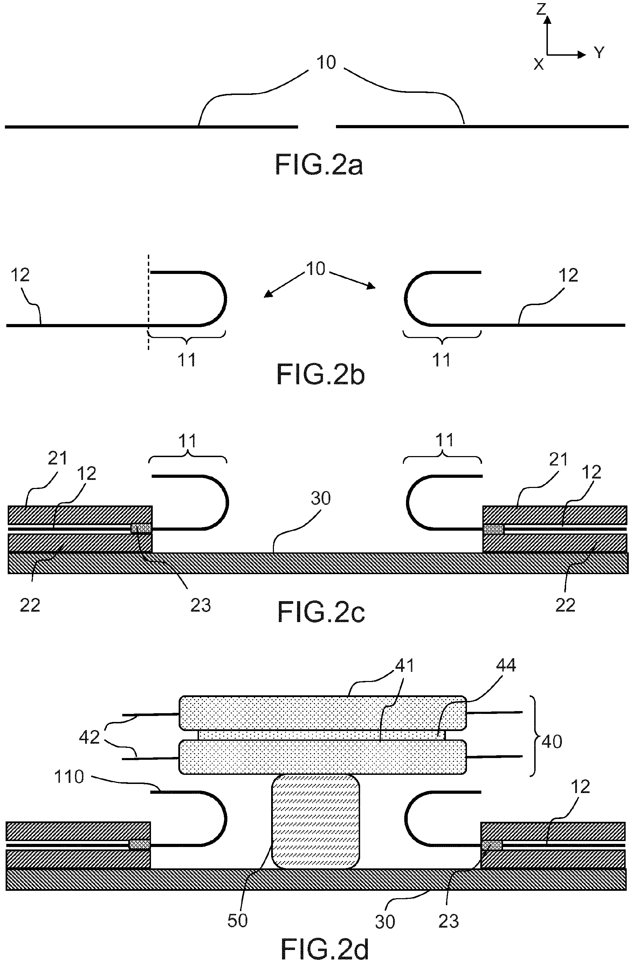

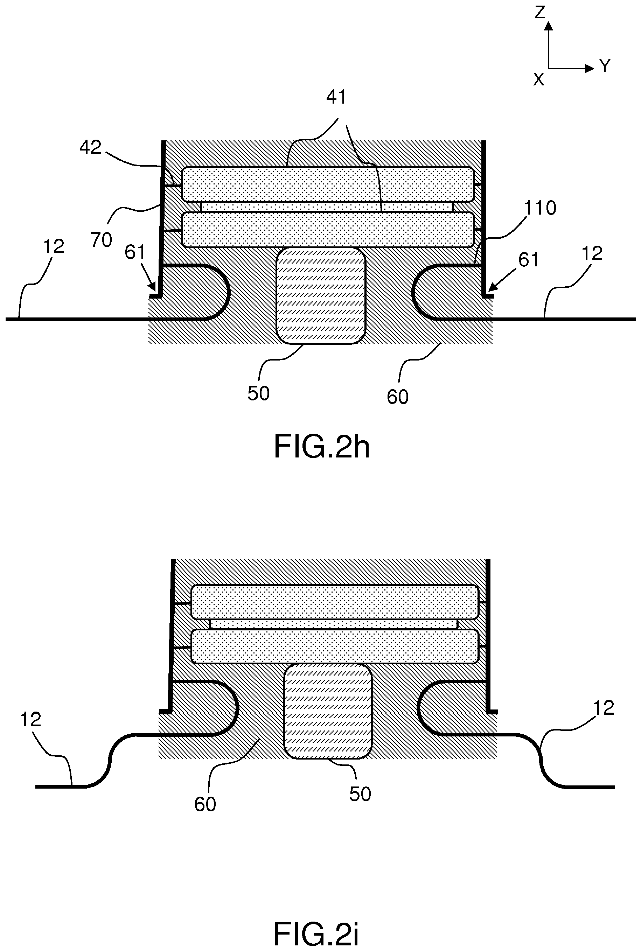

Il comprend une étape de préparation d'une grille de connexion 100 telle que montrée figure 1 en perspective et figure 2a en coupe selon AA', qui comprend des broches métalliques 10 ayant chacune deux extrémités, l'une vers l'intérieur de la grille, l'autre vers l'extérieur de la grille. Cette préparation consiste :
- à plier à environ 180° les extrémités intérieures des broches 10 de la grille 100 (figure 2b). Les broches forment ainsi un J couché comme on peut le voir sur les figures. On peut alors définir deux parties dans chaque broche 10 auxquelles correspondent deux parties dans la grille : une partie 11 incluant ces extrémités pliées et destinées à être moulées (désignée partie à mouler ou partie interne), et une partie 12 qui ne sera pas moulée mais protégée (désignée partie à protéger ou partie externe) et qui formera les broches externes du module 3D, comme on le verra plus loin. Les dimensions 3D de cette partie interne 11 dépendent de l'angle, et éventuellement du rayon de courbure et de la position (plus ou moins près de l'extrémité) du pliage, mais elles sont déterminées afin que les deux extrémités 110 et 12 de chaque broche sortent du module 3D sur une même face verticale 43 comme on le verra plus loin notamment sur les figures 2h et 2i ; c'est pourquoi un pliage compris entre 135° et 180° peut être envisagé mais un pliage à 180° est préféré comme montré sur les figures,
- à déposer sur toute la grille (partie 11 à mouler et partie 12 externe) ainsi pliée un revêtement métallique compatible d'étapes ultérieures de collage et/ou de brasage de la partie externe lors de l'assemblage du module 3D à une carte imprimée ; il s'agit typiquement d'un revêtement d'Or ou de Nickel ;
- à placer (figure 2c) la partie 12 de la grille métallisée à protéger entre un élément de protection inférieur 22 et un élément de protection supérieur 21, telles que des plaques de protection, en laissant libre la partie interne à mouler 11; ces éléments de protection sont typiquement en métal ou en céramique ou en polymères ;
- de préférence à disposer un élément d'étanchéité 23 entre les deux éléments de protection 21 et 22, pour éviter lors de l'étape de moulage que la résine de moulage ne pénètre entre ces éléments de protection,
- et à placer cet ensemble grille et éléments de protection sur un support 30 de métal ou céramique ou polymères, l'extrémité courbée de la partie interne étant bien sûr dirigée selon Z vers le haut (Z>0) comme on peut le voir sur les figures.

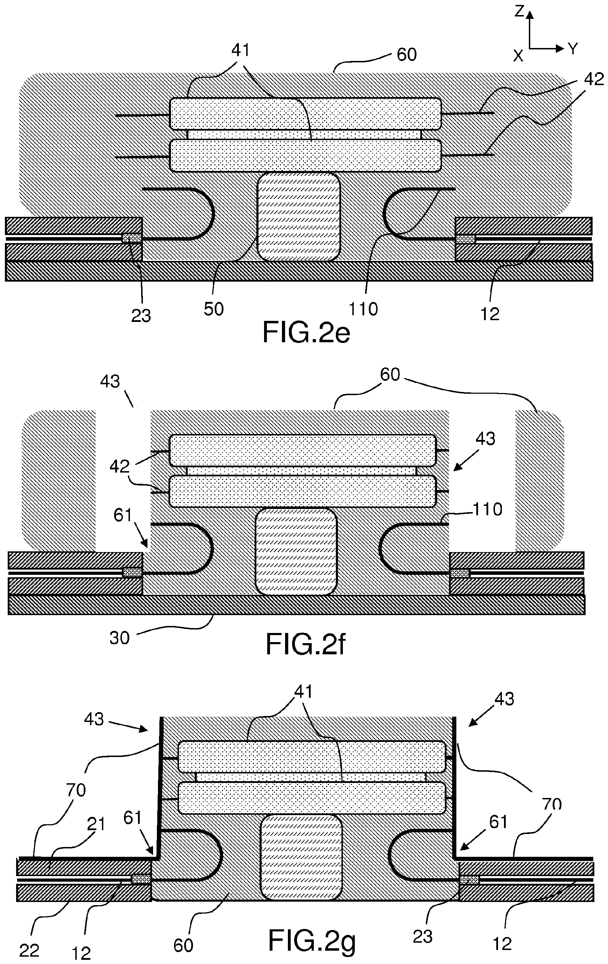

La grille étant ainsi préparée,
- placer (figure 2d) au centre 101 de la grille (montrée figure 1) un empilement 40 de boîtiers 41 et/ou de circuits imprimés (on a de préférence dans l'empilement soit des boîtiers soit des circuits imprimés, mais on peut éventuellement avoir les deux), assemblés éventuellement par une colle 44, et équipés chacun d'au moins un composant électronique (non représenté sur les figures) et de pattes extérieures 42 d'interconnexion électrique entre boîtiers et/ou circuits imprimés, de manière à superposer au moins partiellement les pattes extérieures 42 des boîtiers et/ou circuits imprimés sur la partie à mouler 11 sans la déformer ; à cet effet on place l'empilement 40 par exemple sur une cale 50 en métal, en céramique ou en polymère de hauteur prédéterminée, cette cale pouvant être placée sur le support 30 au centre de la grille comme montré sur la figure, ou sur le cadre de la grille (cadre 102 sur la figure 1) si les dimensions de l'empilement le permettent,
- mouler (figure 2e) dans une résine 60 de type époxyde, l'empilement 40 avec ses pattes extérieures 42 et la partie à mouler 11 de la grille en recouvrant partiellement l'élément de protection supérieur 21,
- découper (figure 2f) la résine 60 selon Z en laissant affleurer les sections conductrices des pattes extérieures 42 et des broches 110 de la partie moulée 11, sans atteindre la partie protégée 12 des broches, et en maîtrisant cette découpe verticale pour de préférence ne pas entamer l'élément de protection supérieur 21. Selon le positionnement de l'axe de découpe, un épaulement de résine 61 peut exister au niveau de l'élément supérieur de protection ;
- retirer (figure 2g) la résine 60 recouvrant l'élément de protection supérieur 21,
- métalliser, avec un revêtement métallique 70 constitué d'un multicouche de métaux conventionnels de cuivre et/ou de nickel et d'or, les faces découpées 43 présentant les sections conductrices, cette métallisation étant ainsi effectuée tout en maintenant les protections 21, 22 sur la partie externe 12 des broches ; de fait l'élément de protection supérieur 21 se trouve également métallisé,
- retirer le support 30 ; cette étape peut également intervenir avant la métallisation,
- retirer (figure 2h) les éléments de protection 21, 22 et l'éventuel élément d'étanchéité 23 pour dégager la partie externe 12 des broches et ainsi obtenir les broches externes 12 du module 3D.

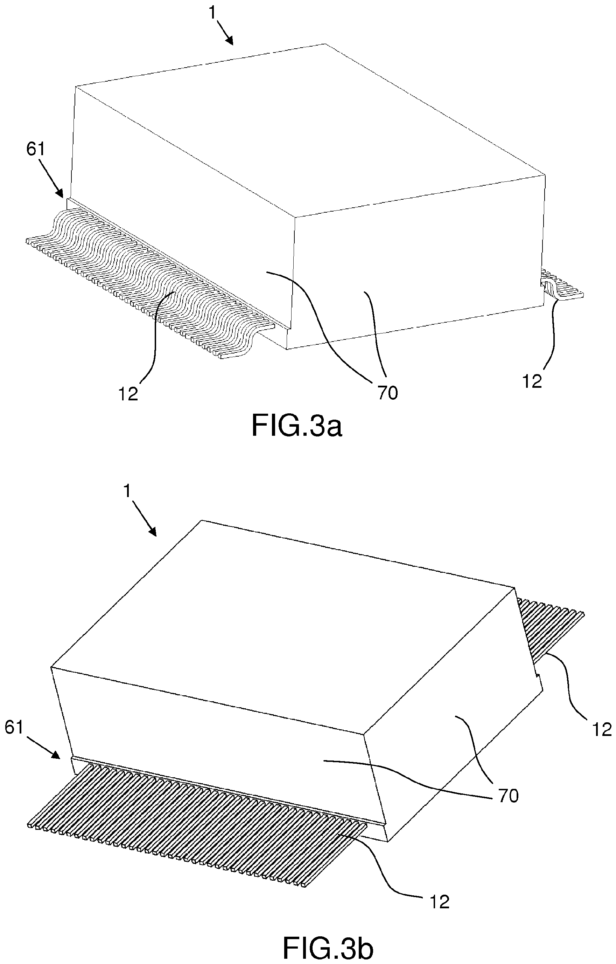

Ces broches externes 12 peuvent être cambrées comme montré figure 2i et figure 3a où est montré un module 1 à trois dimensions (module 3D) ainsi obtenu. On peut voir figure 3b un module 3D à broches externes 12 laissées plates.

Au niveau de la grille 100, les extrémités des broches 10 peuvent être solidarisées entre elles comme on peut le voir figures 1, 4a et 5 pour faciliter le pliage et pour qu'il soit homogène, qu'il s'agisse du premier pliage pour former la partie interne ou du pliage pour former la cambrure des broches externes en « gullwing ». Mais dès que le pliage est réalisé, elles sont désolidarisées.

Le système d'interconnexion électrique du module 3D avec l'extérieur peut ne pas comporter de circuit imprimé mais seulement les broches 10 issues de la grille 100, comme sur l'exemple des figures. Eventuellement, l'empilement 40 comporte un tel circuit imprimé sur lequel sont ensuite empilés des boîtiers et/ou d'autres circuits imprimés.

Bien sûr les faces métallisées 43 sont gravées pour réaliser l'interconnexion verticale du module 3D. Cette étape peut être effectuée juste après la métallisation avant le retrait des éléments de protection. Le module 3D peut aussi être livré au client sans gravures, si celui-ci préfère les réaliser lui-même ; elles seront alors réalisées après le retrait des éléments de protection, voire même après l'éventuelle étape de cambrure des broches externes.

On a représenté sur les figures un module 3D avec un empilement de boîtiers 42 à deux faces 43 d'interconnexion verticale (les sections des conducteurs de l'empilement affleurent sur deux faces opposées) et donc réalisé à partir d'une grille 100 comportant deux groupes de broches 10 correspondants.

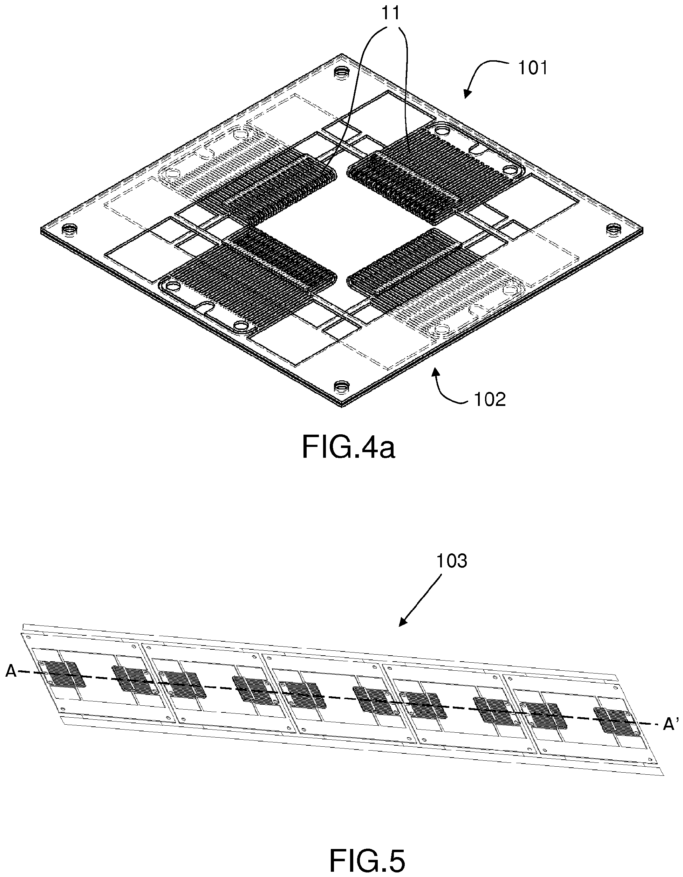

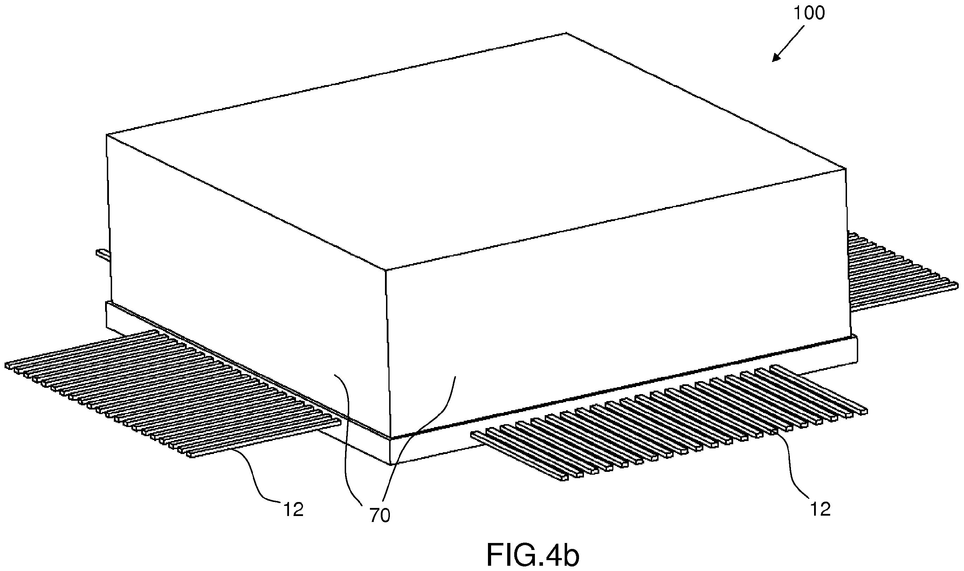

On peut également fabriquer un module 3D à quatre faces d'interconnexion verticale (les sections des conducteurs de l'empilement affleurent sur quatre faces opposées). On utilisera alors comme grille de connexion 100 une grille comportant deux sous-grilles 101, 102 comportant chacune deux groupes de broches tels que décrits précédemment. Ces sous-grilles sont placées l'une sur l'autre et perpendiculairement l'une par rapport à l'autre comme on peut le voir figure 4a, où les broches sont montrées repliées. Les broches de la première sous-grille 101 sont connectées à deux faces opposées de l'empilement 40, et celles de la deuxième sous-grille 102 sont connectées aux deux autres faces opposées de l'empilement 40 comme montré figure 4b.

Nous avons décrit la fabrication d'un seul module 3D à broches externes de connexion, mais les étapes du procédé peuvent être réalisées collectivement en disposant de plusieurs grilles de connexion et d'autant d'empilements de boîtiers, chaque grille étant destinée à l'interconnexion d'un empilement comme décrit précédemment, ces grilles étant en outre solidarisées sous forme d'une multigrille 103. Un exemple d'une telle multigrille 103 à 5 motifs, prête à recevoir 5 empilements de boîtiers et/ou de circuits imprimés est montrée figure 5.

Bien que l'invention ait été décrite en liaison avec des modes de réalisation particuliers, il est bien évident qu'elle n'y est nullement limitée et qu'elle comprend tous les équivalents techniques des moyens décrits si ceux-ci sont couverts par les revendications 1 -7 suivantes.

## Revendications

1. Procédé de fabrication d'au moins un module électronique 3D (1) comprenant chacun un empilement (40) selon une direction Z de boîtiers électroniques (41) et/ou de circuits imprimés, disposé sur un système d'interconnexion électrique du module 3D avec l'extérieur à broches métalliques (10) ayant chacune deux extrémités, **caractérisé en ce qu'**il comporte les étapes suivantes :
- à partir d'une grille d'interconnexion (100) qui comprend des broches métalliques (10) ayant chacune deux extrémités, l'une vers l'intérieur de la grille, l'autre vers l'extérieur de la grille, plier à environ 180° les extrémités intérieures des broches (10) pour obtenir une partie de grille (11) dite interne incluant les extrémités pliées destinées à être moulées, l'autre partie (12) dite externe incluant les extrémités extérieures non pliées, les deux extrémités de chaque broche étant destinées à émerger du module 3D sur une même face découpée selon Z,
- déposer sur les broches (10) ainsi pliées un revêtement métallique compatible d'étapes ultérieures de collage et/ou de brasage de la partie externe,
- placer la partie externe (12) de la grille métallisée entre un élément de protection inférieur (22) et un élément de protection supérieur (21) en laissant libre la partie interne (11), et placer la grille (100) et les éléments de protection (21, 22) sur un support (30),
- placer chaque empilement (40) de boîtiers (41) et/ou de circuits imprimés équipés chacun d'au moins un composant électronique et de pattes extérieures (42) d'interconnexion électrique entre boîtiers et/ou circuits imprimés, de manière à superposer les pattes extérieures (42) sur la partie interne (11),
- mouler dans une résine (60) de type époxyde, l'empilement (40), les pattes extérieures (42) et la partie interne (11) en recouvrant partiellement l'élément de protection supérieur (21),
- découper la résine (60) selon Z en laissant affleurer les sections conductrices des pattes extérieures (42) et des extrémités (110) des broches de la partie interne (11) et en formant ainsi des faces découpées selon Z (43), et retirer la résine (60) de l'élément de protection supérieur (21),
- métallisation des faces découpées (43) présentant les sections conductrices,
- retrait du support (30),
- retrait des éléments de protection (21, 22) pour dégager les broches de la partie externe (12).

2. Procédé de fabrication d'au moins un module électronique 3D selon la revendication précédente, **caractérisé en ce que** les broches de la partie externe (12) sont cambrées ou plates.

3. Procédé de fabrication d'au moins un module électronique 3D selon l'une des revendications précédentes, **caractérisé en ce que** les faces découpées métallisées (43) sont gravées pour réaliser une interconnexion verticale.

4. Procédé de fabrication d'au moins un module électronique 3D selon l'une des revendications précédentes, **caractérisé en ce qu'**un élément d'étanchéité (23) est disposé entre les éléments de protection (21, 22) lors du placement de la partie externe (12) entre ces éléments de protection et qu'il est retiré lors du retrait des éléments de protection.

5. Procédé de fabrication d'au moins un module électronique 3D selon l'une des revendications précédentes, **caractérisé en ce que** les pattes extérieures (42) des boîtiers (41) et/ou des circuits imprimés sont présentes sur quatre côtés et **en ce que** la grille d'interconnexion (100) comporte deux sous-grilles (101, 102) placées l'une sur l'autre et perpendiculairement l'une par rapport à l'autre et comportant chacune des broches, les broches de la première sous-grille (101) étant connectées à deux faces opposées de l'empilement (40), les broches de la deuxième sous-grille (102) étant connectées aux deux autre faces opposées de l'empilement (40).

6. Procédé de fabrication de plusieurs modules électroniques 3D selon l'une des revendications précédentes, **caractérisé en ce que** la grille est une multigrille (103).

7. Module électronique 3D (1) comportant :
- un empilement (40) de boîtiers (41) et/ou de circuits imprimés électroniques équipés chacun d'au moins un composant électronique et de pattes extérieures (42) d'interconnexion électrique entre boîtiers et/ou circuits imprimés, cet empilement étant moulé dans une résine (60),
- selon la direction de l'empilement, des faces d'interconnexion (43) des boîtiers et/ou des circuits imprimés, au niveau desquelles affleurent les sections conductrices des pattes extérieures (42), les pattes extérieures étant enfouies dans la résine, et
- assemblé à l'empilement, un système de connexion du module 3D avec l'extérieur, à broches métalliques (10) ayant chacune deux extrémités qui émergent sur une même face d'interconnexion qui est une desdites faces d'interconnexion (43), la partie de chaque broche métallique entre ses deux extrémités qui émergent étant enfouie dans ladite résine, une des deux extrémités de chaque broche affleurant au niveau de la face d'interconnexion correspondant à cette broche,
- du métal sur lesdites faces d'interconnexion pour réaliser l'interconnexion verticale du module 3D.

## Patentansprüche

1. Verfahren zur Herstellung von mindestens einem elektronischen 3D-Modul (1), welches jeweils einen Stapel (40) in einer Richtung Z von Steuergeräten (41) und/oder von Leiterplatten beinhaltet, welcher an einem elektrischen Verbindungssystem des 3D-Moduls mit dem Außenbereich, versehen mit Metallstiften (10), angeordnet ist, welche jeweils zwei Enden besitzen, **dadurch gekennzeichnet, dass** es folgende Schritte beinhaltet:
- anhand eines Verbindungsgitters (100), welches Metallstifte (10) beinhaltet, welche jeweils zwei Enden besitzen, wobei eines zum Inneren des Gitters und das andere zum Äußeren des Gitters weist, Biegen um ungefähr 180° der inneren Enden der Stifte (10), um einen Teil des Gitters (11) zu erzielen, genannt innerer Teil, welcher die gebogenen Enden umfasst, welche dazu bestimmt sind, geformt zu werden, wobei der andere Teil (12), genannt äußerer Teil, die nicht gebogenen äußeren Enden umfasst, wobei die beiden Enden eines jeden Stiftes dazu bestimmt sind, aus dem 3D-Modul auf einer selben Seite herauszuragen, welche entlang Z ausgeschnitten ist,
- Ablagern auf den so gebogenen Stiften (10) einer metallenen Beschichtung, welche mit späteren Schritten des Klebens und/oder des Lötens des äußeren Teils kompatibel ist,
- Platzieren des äußeren Teils (12) des metallisierten Gitters zwischen einem unteren Schutzelement (22) und einem oberen Schutzelement (21), indem der innere Teil (11) frei gelassen wird, und Platzieren des Gitters (100) und der Schutzelemente (21, 22) auf einem Halter (30),
- Platzieren eines jeden Stapels (40) von Steuergeräten (41) und/oder Leiterplatten, welche jeweils mit mindestens einem elektronischen Bauteil und mit äußeren Laschen (42) zur elektrischen Verbindung zwischen Steuergeräten und/oder Leiterplatten ausgerüstet sind, so dass die äußeren Laschen (42) an der inneren Seite (11) übereinander gelegt werden,
- Formen in einem Harz (60) vom Typ Epoxidharz des Stapels (40), der äußeren Laschen (42) und des inneren Teils (11), indem das obere Schutzelement (21) teilweise bedeckt wird,
- Zerschneiden des Harzes (60) entlang Z, wobei die leitfähigen Abschnitte der äußeren Laschen (42) und der Enden (110) der Stifte des inneren Teils (11) bloßgelegt werden, und indem so ausgeschnittene Seiten entlang Z (43) gebildet werden, und Entfernen des Harzes (60) vom oberen Schutzelement (21),
- Metallisieren der ausgeschnittenen Seiten (43), welche die leitfähigen Abschnitte aufweisen,
- Entfernen des Halters (30),
- Entfernen der Schutzelemente (21, 22) zum Freilegen der Stifte des äußeren Teils (12).

2. Verfahren zur Herstellung von mindestens einem elektronischen 3D-Modul nach dem vorhergehenden Anspruch, **dadurch gekennzeichnet, dass** die Stifte des äußeren Teils (12) gekrümmt oder flach sind.

3. Verfahren zur Herstellung von mindestens einem elektronischen 3D-Modul nach einem der vorhergehenden Ansprüche, **dadurch gekennzeichnet, dass** die ausgeschnittenen, metallisierten Seiten (43) graviert werden, um eine vertikale Verbindung herzustellen.

4. Verfahren zur Herstellung von mindestens einem elektronischen 3D-Modul nach einem der vorhergehenden Ansprüche, **dadurch gekennzeichnet, dass** ein Dichtelement (23) zwischen den Schutzelementen (21, 22) beim Platzieren des äußeren Teils (12) zwischen diesen Schutzelementen angeordnet wird, und es beim Entfernen der Schutzelemente entfernt wird.

5. Verfahren zur Herstellung von mindestens einem elektronischen 3D-Modul nach einem der vorhergehenden Ansprüche, **dadurch gekennzeichnet, dass** die äußeren Laschen (42) der Steuergeräte (41) und/oder der Leiterplatten an vier Seiten vorhanden sind und dadurch, dass das Verbindungsgitter (100) zwei Untergitter (101, 102) besitzt, welche eines über dem anderen und rechtwinklig zueinander platziert sind und jeweils Stifte beinhalten, wobei die Stifte des ersten Untergitters (101) mit zwei gegenüberliegenden Seiten des Stapels (40) verbunden sind, wobei die Stifte des zweiten Untergitters (102) mit den beiden anderen gegenüberliegenden Seiten des Stapels (40) verbunden sind.

6. Verfahren zur Herstellung mehrerer elektronischer 3D-Module nach einem der vorhergehenden Ansprüche, **dadurch gekennzeichnet, dass** das Gitter ein Multigitter (103) ist.

7. Elektronisches 3D-Modul (1), Folgendes beinhaltend:
- einen Stapel (40) von Steuergeräten (41) und/oder elektronischen Leiterplatten, welche jeweils mit mindestens einem elektronischen Bauteil und mit äußeren Laschen (42) zur elektrischen Verbindung zwischen Steuergeräten und/oder Leiterplatten ausgerüstet sind, wobei dieser Stapel in einem Harz (60) geformt ist,
- in Richtung des Stapels, Verbindungsseiten (43) zum Verbinden der Steuergeräte und/oder der Leiterplatten, wo die leitfähigen Abschnitte der äußeren Laschen (42) bloß liegen, wobei die äußeren Laschen in dem Harz eingebettet sind, und
- montiert an dem Stapel, ein Verbindungssystem zum Verbinden des 3D-Moduls mit dem Außenbereich, versehen mit Metallstiften (10), welche jeweils zwei Enden besitzen, welche auf einer gleichen Verbindungsseite hervorstehen, welche eine der Verbindungsseiten (43) ist, wobei der Teil eines jeden Metallstifts zwischen seinen beiden hervorstehenden Enden in dem Harz eingebettet ist, wobei eines der beiden Enden eines jeden Stiftes auf Höhe der Verbindungsseite bloß liegt, welche diesem Stift entspricht,
- Metall an den Verbindungsseiten, um die vertikale Verbindung des 3D-Moduls herzustellen.

## Claims

1. Process for manufacturing at least one 3D electronic module (1) each comprising a stack (40) in a Z direction of electronic packages (41) and/or printed wiring boards, which stack is placed on a system for electrically interconnecting the 3D module with the exterior comprising metal leads (10) each having two ends, the process being **characterized in that** it includes the following steps:
- starting with a lead frame (100) that comprises metal leads (10) each having two ends, one toward the interior of the frame and the other toward the exterior of the frame, folding by about 180° the interior ends of the leads (10) in order to obtain what is referred to as an internal frame portion (11) including the folded ends, which are intended to be moulded, the other portion (12), which is referred to as an external portion, including the unfolded exterior ends, the two ends of each lead being intended to emerge from the 3D module on a same face cut along Z,
- depositing on the leads (10) thus folded a metal coating compatible with subsequent steps of adhesive bonding and/or soldering of the external portion,
- placing the external portion (12) of the metallized frame between a lower protective element (22) and an upper protective element (21) while leaving the internal portion (11) free, and placing the frame (100) and the protective elements (21, 22) on a carrier (30);
- placing each stack (40) of packages (41) and/or printed wiring boards equipped each with at least one electronic component and exterior tabs (42) for electrically interconnecting packages and/or printed wiring boards, so as to superpose the exterior tabs (42) on the internal portion (11);
- moulding, in an epoxy resin (60), the stack (40), the exterior tabs (42) and the internal portion (11) by partially covering the upper protective element (21);
- cutting the resin (60) along Z by leaving flush the conductive sections of the exterior tabs (42) and of the ends (110) of the leads of the internal portion (11) and thereby forming faces cut along Z (43), and removing the resin (60) from the upper protective element (21);
- metallizing the cut faces (43) presenting the conductive sections;
- removing the carrier (30);
- removing the protective elements (21, 22) in order to expose the leads of the external portion (12).

2. Process for manufacturing at least one 3D electronic module according to the preceding claim, **characterized in that** the leads of the external portion (12) are bent or flat.

3. Process for manufacturing at least one 3D electronic module according to one of the preceding claims, **characterized in that** the metallized cut faces (43) are etched to produce a vertical interconnection.

4. Process for manufacturing at least one 3D electronic module according to one of the preceding claims, **characterized in that** a sealing element (23) is placed between the protective elements (21, 22) during the placement of the external portion (12) between these protective elements and that it is removed during the removal of the protective elements.

5. Process for manufacturing at least one 3D electronic module according to one of the preceding claims, **characterized in that** the exterior tabs (42) of the packages (41) and/or of the printed wiring boards are present on four sides and **in that** the interconnecting frame (100) includes two subframes (101, 102) placed one on the other and perpendicular one relative to the other and each including leads, the leads of the first subframe (101) being connected to two opposite faces of the stack (40), the leads of the second subframe (102) being connected to the two other opposite faces of the stack (40).

6. Process for manufacturing a plurality of 3D electronic modules according to one of the preceding claims, **characterized in that** the frame is a multiframe (103).

7. 3D electronic module (1) including:
- a stack (40) of packages (41) and/or printed electronic wiring boards each equipped with at least one electronic component and exterior tabs (42) for electrical interconnection of packages and/or printed wiring boards, this stack being moulded in a resin (60),
- in the direction of the stack, interconnection faces (43) for interconnection of the packages and/or printed wiring boards, where the conductive sections of the exterior tabs (42) are flush, the exterior tabs being embedded in the resin; and
- assembled with the stack, a system for connecting the 3D module to the exterior, with metal leads (10) each having two ends that emerge from a same interconnection face that is one of said interconnection faces (43), the portion of each metal lead between these two emerging ends being embedded in said resin, one of the two ends of each lead being flush at the interconnection face corresponding to this lead,
- metal on said interconnection faces for producing the vertical interconnection of the 3D module.
